# EUROPÄISCHE PATENTSCHRIFT

(11) **EP 2 397 020 B1**
(45) Veröffentlichungstag und Bekanntmachung des Hinweises auf die Patenterteilung: **03.04.2013**
(21) Anmeldenummer: 10704079.2
(22) Anmeldetag: 08.02.2010
(51) Int. Cl.: H05K 7/14, H05K 5/02, H02M 7/00

(54) **HALTERUNG FÜR EINEN WECHSELRICHTER UND VERFAHREN ZUR MONTAGE EINES WECHSELRICHTERS**
MOUNTING FOR A DC-AC CONVERTER AND METHOD FOR FITTING A DC-AC CONVERTER
FIXATION POUR UN ONDULEUR, ET PROCÉDÉ DE MONTAGE D'UN ONDULEUR

(30) Priorität: 12.02.2009 AT 2402009
(43) Veröffentlichungstag der Anmeldung: 21.12.2011
(73) Patentinhaber: Fronius International GmbH, 4643 Pettenbach (AT)
(72) Erfinder: STOCKINGER, Walter, 4542 Nussbach (AT); GRAF, Jürgen, A-4600 Wels (AT); LEBELHUBER, Markus, A-4655 Vorchdorf (AT)
(74) Vertreter: Sonn & Partner Patentanwälte
(86) Internationale Anmeldenummer: PCT/AT2010/000036
(87) Internationale Veröffentlichungsnummer: WO 2010/091445

(56) Entgegenhaltungen:
- EP-A1- 1 524 890
- WO-A1-2004/026013
- US-A1- 2004 201 972

## Beschreibung

Die Erfindung betrifft eine Halterung für einen Wechselrichter einer Photovoltaikanlage nach dem Oberbegriff des Anspruchs 1.

Ebenso betrifft die Erfindung ein Verfahren zur Montage eines Wechselrichters einer Photovolatikanlage nach dem Oberbegriff des Anspruchs 4.

Aus der DE 20 2006 009 906 U1 ist ein Gestell zur lösbaren Anbringung einer Vielzahl von Wechselrichtern bekannt. Dabei müssen die einzelnen Wechselrichter mit ihren Strom zu- und abführenden Kabeln mit den entsprechenden Klemmen eines Klemmblockes verbunden werden.

Aus der DE 10 2006 028 522 A1 ist eine Wandhalterung für einen Wechselrichter bekannt, welche Haltemittel zur lösbaren Aufnahme des Wechselrichters aufweist. Nachteilig ist hierbei, dass die Anschlusskabel direkt am Wechselrichter einzeln anzuschließen sind. Dementsprechend muss eine ausreichende Zugänglichkeit im Bereich der Anschlüsse gewährleistet sein, wodurch der Platzbedarf des Wechselrichters steigt. Ebenso werden insbesondere Wartungsarbeiten im laufenden Betrieb des Wechselrichters erschwert, da der Wechselrichter geöffnet werden muss und jedes Anschlusskabel einzeln abgeklemmt werden muss. Somit erhöhen sich die Kosten der Wartungsarbeiten.

Aus der WO 2008/028205 A1 ist ein modulares Wechselrichtersystem bekannt, bei dem der Wechselrichter aus einem Anschlussmodul und einem Leistungsmodul gebildet wird, welche über entsprechende Steckelemente miteinander verbunden werden. Hierbei ist von Nachteil, dass der Wechselrichter aus zwei getrennten Gehäuseteilen besteht, welche jeweils beispielsweise an einer Wand montiert werden müssen. Somit sind zwei getrennte Wandhalterungen erforderlich, welche mit hoher Genauigkeit montiert werden müssen, damit die Steckelemente verbunden werden können. Zusätzlich ist das Anschlussmodul für mehrere Wechselrichter bzw. Leistungsmodule ausgelegt und entsprechend großzügig dimensioniert. Dies ist bei größeren Photovoltaikanlagen mit mehreren hundert kW bis zu einigen MW nicht relevant.

Die US 2004/201972 A1 zeigt eine Halterung für einen Wechselrichter der gegenständlichen Art, bei der keine Trennung der Führung des Wechselrichters in der Halterung stattfindet.

Die WO 2004/026013 A1 zeigt ein Gehäuse eines Gerätes, welches die Elektronik beispielsweise vor Spritzwasser schützt. Dabei wird der Elektronikteil mit einer Anschlussbox direkt verbunden.

Auch die EP 1 524 890 A1 zeigt keine Trennung der Führung eines Wechselrichters in einer Halterung.

Im Allgemeinen werden die Anschlusskabel mit speziellen, sogenannten Solarsteckern angeschlossen. Dabei muss am Ende jedes einzelnen Anschlusskabels ein Stecker montiert werden, welcher anschließend einzeln mit einer speziellen Kupplung im Wechselrichter verbunden werden muss. Zur Montage der Stecker sind entsprechende Werkzeuge erforderlich, um die Stecker beispielsweise crimpen zu können, sodass der erforderliche elektrische Kontakt gewährleistet ist. Nachteilig ist hierbei, dass die speziellen Stecker bzw. Kupplungen zum einen im Wesentlichen nur auf einen Querschnitt des Anschlusskabels ausgelegt sind und zum anderen zwischen den Herstellern nicht kompatibel sind. Dadurch wird der Aufwand für den Monteur erhöht und dementsprechend steigen die Kosten.

Die Aufgabe der Erfindung besteht in der Schaffung einer oben genannten Halterung und eines oben genannten Montageverfahrens, durch welche der Wechselrichter möglichst einfach und schnell montiert werden kann.

Die Aufgabe der Erfindung wird dadurch gelöst, dass die Halterung durch eine Rückwand und zwei Seitenwände gebildet ist und die Führungsvorrichtungen in den Seitenwänden der Halterung integriert sind, wobei die Führungsvorrichtungen durch eine erste horizontale Führungsnut und eine zweite vertikale Führungsnut zur Führung des Wechselrichters in zumindest zwei Schritten ausgebildet ist, sodass bei der Führung nach unten entlang der vertikalen Führungsnut die automatische Kontaktierung zwischen dem ersten Teil und dem zweiten Teil der Steckverbindung erfolgt.

Weiters wird die Aufgabe der Erfindung auch durch ein oben genanntes Verfahren gelöst, wobei ein Gehäuse des Wechselrichters in einer Halterung eingehängt wird, welche Halterung durch eine Rückwand und zwei Seitenwände gebildet ist, und Führungsvorrichtungen in den Seitenwänden der Halterung integriert sind, wobei die Führungsvorrichtungen durch eine erste horizontale Führungsnut und eine zweite vertikale Führungsnut zur Führung des Wechselrichters in zumindest zwei Schritten ausgebildet ist, und der Wechselrichter über jeweils zumindest ein Anschlusskabel mit dem zumindest einem Solarmodul und einem Wechselspannungsnetz verbunden wird, wobei zuerst die Anschlusskabel an einem mit der Halterung verbundenen Teil einer Steckverbindung angeschlossen werden, und dann der mit einem zweiten Teil der Steckverbindung versehene Wechselrichter durch das Einhängen bei der Führung nach unten entlang der vertikalen Führungsnut in der Halterung automatisch mit dem ersten Teil der Steckverbindung kontaktiert wird.

Vorteilhaft ist hierbei, dass die Anschlusskabel am ersten Teil der Steckverbindung angeschlossen werden können, bevor der Wechselrichter montiert wird. Somit kann ein alleinig funktionierender Wechselrichter an der Halterung eingehängt und über die Anschlusskabel mit den Solarmodulen und dem Wechselspannungsnetz verbunden werden. Von Vorteil ist auch, dass der Wechselrichter im Servicefall nicht von den Anschlusskabeln getrennt werden muss. Somit sind ein schneller Tausch und eine entsprechend kurze Ausfallzeit des Wechselrichters gewährleistet. Vorteilhafterweise wird das Gewicht des Wechselrichters von der Halterung und nicht von der Steckverbindung getragen, sodass die Langlebigkeit der Steckverbindung gegeben ist. Die Montage kann auch unter Spannung, also beispielsweise tagsüber, wenn von den Solarmodulen eine Spannung zur Verfügung steht, erfolgen, ohne dass eine Gefahr für den Monteur besteht. Dies wird dadurch gewährleistet, dass ein Öffnen des Wechselrichters nicht notwendig ist.

Durch die erfindungsgemäße Halterung kann auch ein kompakter Aufbau des Wechselrichters erreicht werden, da der Platzbedarf für die Steckverbindung zur Verbindung des Wechselrichters mit den Anschlusskabeln sehr gering ist. Dies ist auch darauf zurückzuführen, dass im Wesentlichen keine Zugänglichkeit zur Steckverbindung erforderlich ist, da die Anschlusskabel bereits vor der Montage des Wechselrichters angeschlossen sind. Dadurch kann insbesondere auch der Stecker der Steckverbindung im Wechselrichter durch das Gehäuse geschützt werden. Auch kann die Länge der weiterführenden Leitungen der Anschlusskabel äußerst kurz gehalten werden, sodass Leitungsverluste minimiert werden. Die Anschlusskabel können ohne zusätzlichem Aufwand, wie das Montieren eines Steckers an jedem einzelnen Anschlusskabel, am ersten Teil der Steckverbindung angeschlossen werden.

Weitere Vorteile können aus der nachfolgenden Beschreibung einer Ausführungsform entnommen werden.

Die vorliegende Erfindung wird anhand der beigefügten, schematischen Zeichnungen näher erläutert. Darin zeigen:
Fig. 1 den schematischen Aufbau einer Photovoltaikanlage;
Fig. 2 die erfindungsgemäße Halterung;
Fig. 3 die erfindungsgemäße Halterung mit dem Gehäuse des Wechselrichters vor dem Einhängen;
Fig. 4 ein Schnittbild durch die Halterung mit dem Gehäuse vor dem Einhängen;
Fig. 5 die Halterung und das Gehäuses nach dem Einhängen;
Fig. 6 ein Schnittbild durch die Halterung mit dem Gehäuse des Wechselrichters nach dem Einhängen;
Fig. 7 eine Rückansicht des Gehäuses des Wechselrichters und eines Teils der Halterung bei getrennter Steckverbindung; und
Fig. 8 eine Rückansicht des Gehäuses des Wechselrichters und eines Teils der Halterung bei kontaktierter Steckverbindung.

Einführend wird festgehalten, dass gleiche Teile des Ausführungsbeispiels mit gleichen Bezugszeichen versehen werden.

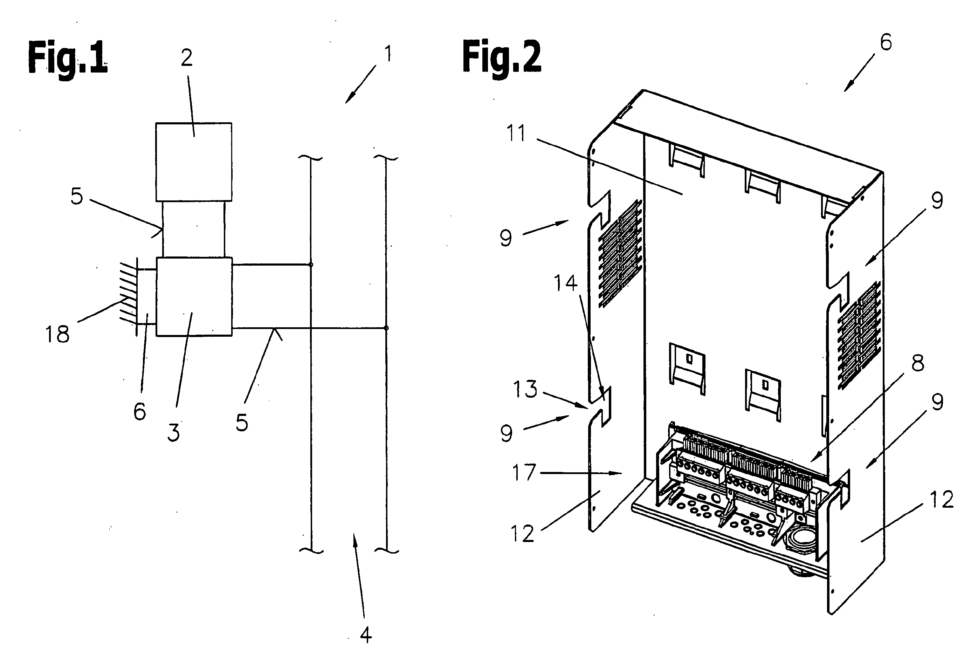

Fig. 1 zeigt ein Blockschaltbild einer Photovoltaikanlage 1, welche einen Wechselrichter 3 umfasst, der mit zumindest einer Energiequelle, wie einem Solarmodul 2 und einem Wechselspannungsnetz 4 bzw. einem Verbraucher verbunden ist. Der Wechselrichter 3 erzeugt aus der vom Solarmodul 2 gelieferten Gleichspannung eine Wechselspannung für das Wechselspannungsnetz 4. Der Wechselrichter 3 ist über entsprechende Anschlusskabel 5 bzw. Anschlussleitungen mit dem Solarmodul 2 und dem Wechselspannungsnetz 4 verbunden. Zusätzlich können auch Anschlusskabel 5 für eine externe Stromversorgung des Wechselrichters 3 vorgesehen sein. Der Wechselrichter 3 ist über eine entsprechende Halterung 6 bevorzugt an einem starren Körper 18, wie einer Wand, einer Decke, einem Dach, usw. befestigt.

Erfindungsgemäß ist die Halterung 6 so ausgebildet, dass bei der Montage des Wechselrichters 3 dieser automatisch über eine an der Halterung 6 befestigte Steckverbindung 7 zumindest mit den Anschlusskabeln 5 der Solarmodule 2 und des Wechselspannungsnetzes 4 verbunden ist.

Sämtliche für den Wechselrichter 3 erforderliche Anschlusskabel 5 - also zumindest jene zur Verbindung der Solarmodule 2 und des Wechselspannungsnetzes 4 - werden an einem ersten Teil 8 der an der Halterung 6 befestigten Steckverbindung 7, angeschlossen. Die Halterung 6 ist bevorzugt bereits an einem festen Körper 18, wie einer Wand, einer Decke, einem Gestell oder dergleichen befestigt. Es können also die Anschlusskabeln 5 angeschlossen werden, ohne dass dazu der Wechselrichter 3 erforderlich ist. In einfacher Weise kann nun der Wechselrichter 3 über zumindest eine geeignete Führungsvorrichtung 9 in der Halterung 6 eingehängt werden, wobei beim Einhängen bzw. Montieren der Wechselrichter 3 automatisch mit den Anschlusskabeln 5 verbunden wird und entsprechend in der Halterung 6 gehalten ist. Dazu weist der Wechselrichter 3 einen zum ersten Teil 8 der Steckverbindung 7 korrespondierend ausgebildeten zweiten Teil 10 der Steckverbindung 7 auf, welche Teile 8, 10 der Steckverbindung 7 beim Einhängen des Wechselrichters 3 in die Halterung 6 automatisch kontaktiert bzw. verbunden werden.

Ein Ausführungsbeispiel der Halterung 6 ist in den Fig. 2 bis 8 dargestellt.

Die Halterung 6 ist durch eine Rückwand 11, zwei Seitenwände 12 und dem ersten Teil 8 der Steckverbindung 7 gebildet. Dabei ist der erste Teil 8 der Steckverbindung 7 als Kupplung ausgebildet. Demzufolge ist der zweite Teil 10 der Steckverbindung 7 am Wechselrichter 3 durch einen zu der Kupplung korrespondierenden Stecker gebildet.

Bevorzugt ist der erste Teil 8 der Steckverbindung 7 im unteren Teil der Halterung 6 angeordnet, sodass der Platzbedarf für die Anschlusskabel 5, welche am ersten Teil 8 der Steckverbindung 7 entsprechend angeschlossen werden, in der Halterung 6 bzw. auch im Wechselrichter 3 gering gehalten werden kann. Die Rückwand 11 kann auch im Bereich des ersten Teils 8 der Steckverbindung 7 bzw. der Kupplung zu einem Winkel geformt sein, sodass der erste Teil 8 bzw. die Kupplung am Winkel aufliegt. Hierbei sind im Bereich des Winkels der Rückwand 11 entsprechende Durchführungen für die Anschlusskabel 5 vorgesehen, welche auch als Zugentlastung für die Anschlusskabel 5 dienen können.

Die Halterung 6 kann auch an die Anforderungen des Wechselrichters 3 angepasst sein, indem beispielsweise Kühlschlitze in den Seitenwänden 12 vorgesehen sind.

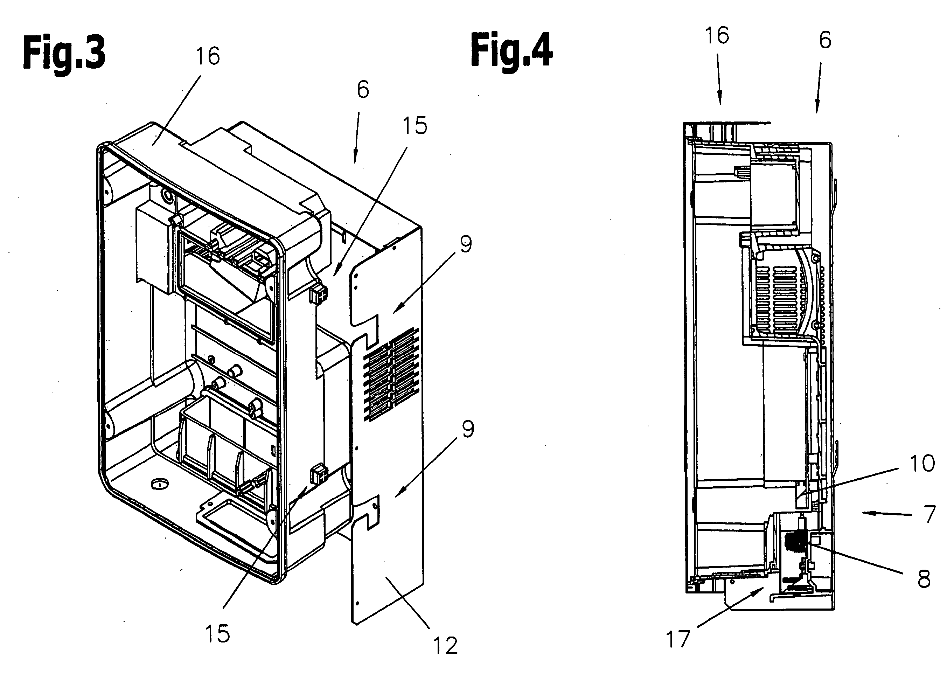

Zum Einhängen bzw. Montieren des Wechselrichters 3 sind in den Seitenwänden 12 der Halterung 6 Führungsvorrichtungen 9 integriert, in welchen jeweils ein an einem Gehäuse 16 des Wechselrichters 3 angeordneter Führungsbolzen 15 geführt ist. Die Führungsvorrichtung 9 ist beispielsweise durch eine erste horizontale Führungsnut 13 und eine zweite vertikale Führungsnut 14 gebildet. Bei der Montage wird der Wechselrichter 3 zuerst in Richtung der Rückwand 11 geschoben und anschließend nach unten in Richtung des ersten Teils 8 der Steckverbindung 7 bzw. Kupplung geführt. Bei der Führung nach unten entlang der vertikalen Führungsnut 14 erfolgt die automatische Kontaktierung zwischen erstem Teil 8 und zweitem Teil 10 der Steckverbindung 7. Die Position der Führungsvorrichtung 9 ist dabei mit der Position der Steckverbindung 7 derart abgestimmt, dass folgende Kriterien im Wesentlichen gleichzeitig erfüllt sind (siehe Fig. 4 bis 6):

Das erste Kriterium ist, dass nach dem Schieben des Wechselrichters 3 in Richtung der Rückwand 11 - also entlang der horizontalen Führungsnut 13 - der erste Teil 8 und der zweite Teil 10 der Steckverbindung 7 bzw. die Kupplung und der Stecker derart positioniert sind, dass die automatische Kontaktierung möglich ist. Die Kupplung und der Stecker sind also übereinander positioniert und durch einen geringen Spalt voneinander getrennt, wie insbesondere aus Fig. 4 ersichtlich. Dies ist durch den entsprechenden Führungsbolzen 15 am Gehäuse 16 des Wechselrichters 3, welcher in der Führungsvorrichtung 9 entsprechend geführt wird, gewährleistet. Somit muss der Wechselrichter 3 lediglich nur noch also entlang der vertikalen Führungsnut 14 nach unten geführt werden, dass die Kontaktierung der Steckverbindung 7 automatisch erfolgt. Dabei wird im Wesentlichen die Länge der Kontaktelemente der Kupplung plus Spalt zurückgelegt. Zusätzlich können auch noch in der Kupplung bzw. im Stecker der Steckverbindung Führungen integriert sein, sodass Beschädigungen der Kontaktelemente im Stecker ausgeschlossen werden können und eine exakte Positionierung möglich wird.

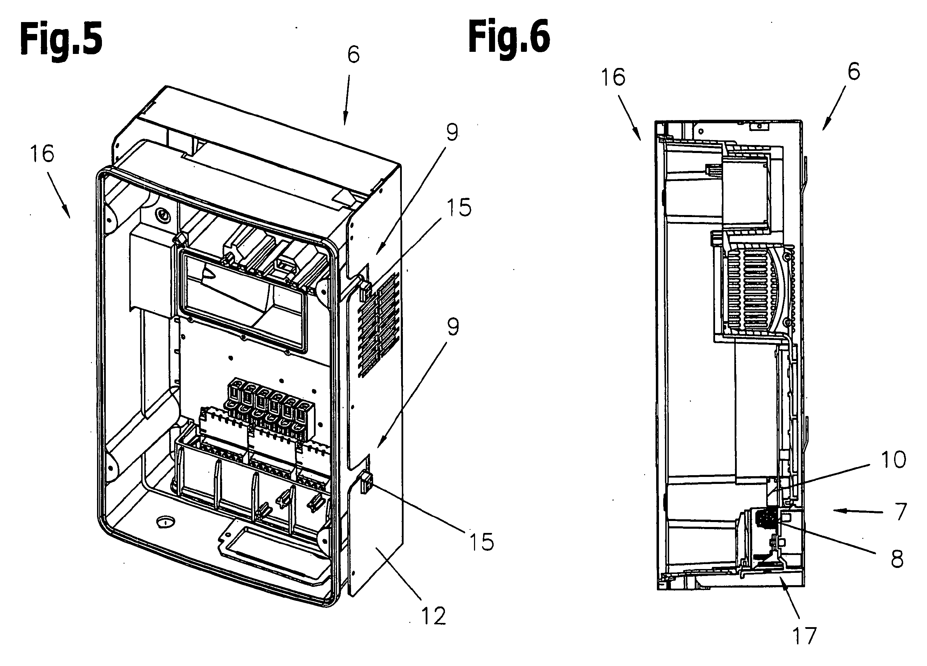

Das zweite Kriterium dient dem generellen Schutz der Steckverbindung 7. Einerseits muss das Gewicht des Wechselrichters 3 durch die Halterung 6 gehalten werden und gleichzeitig die erforderliche Kontaktierung in der Steckverbindung 7 gegeben sein, wie insbesondere aus den Fig. 5 und 6 ersichtlich. Demzufolge ist die Länge der vertikalen Führungsnut 14 der Führungsvorrichtungen 9 darauf abgestimmt, dass der Stecker und die Kupplung der Steckverbindung 7 verbunden werden, ohne dabei das Gewicht des Wechselrichters 3 tragen zu müssen. Die Führungsbolzen 15 liegen am unteren Ende der jeweiligen vertikalen Führungsnut 14 auf und tragen das Gewicht des Wechselrichters 3.

Zusätzlich zum generellen Schutz der Steckverbindung 7 betrifft das dritte Kriterium auch den Schutz des Wechselrichters 3, indem die aufliegenden Führungsbolzen 15 eine ungewollte Veränderung der Position des Wechselrichters 3 in horizontaler Richtung verhindern. Somit soll der Wechselrichter 3 nach dem Einhängen in einer sicheren Position fixiert sein. Dies wird dadurch erreicht, dass die Breite bzw. der Durchmesser der Führungsbolzen 15 im Wesentlichen der Breite der vertikalen Führungsnut 14 entspricht.

Wie aus den Fig. 2 bis 8 ersichtlich, ist der erste Teil 8 der Steckverbindung bzw. die Kupplung an einem Block 17 befestigt, welcher wiederum an der Halterung 6 befestigt ist. Dieser Block 17 hat die Aufgabe, das Innere des Gehäuses 16 des Wechselrichters 3, also die Elektronik, welche den Wechselrichter 3 bildet, vor Feuchtigkeit gemäß der erforderlichen IP-Klasse zu schützen, nachdem der Wechselrichter 3 in der Halterung 6 eingehängt wurde. Zur Realisierung dieses vierten Kriteriums weist das Gehäuse 16 im Bereich der Steckverbindung 7 eine Dichtung auf, welche nach dem Einhängen des Wechselrichters 3 in der Halterung 6 mit dem Block 17 die erforderliche Dichtheit herstellt. Dementsprechend sind auch die angesprochenen Durchführungen im Winkel der Rückwand 11 bzw. im Block 17 mit einer entsprechenden Dichtung ausgestattet. Der Winkel kann auch Teil des Blocks 17 sein.

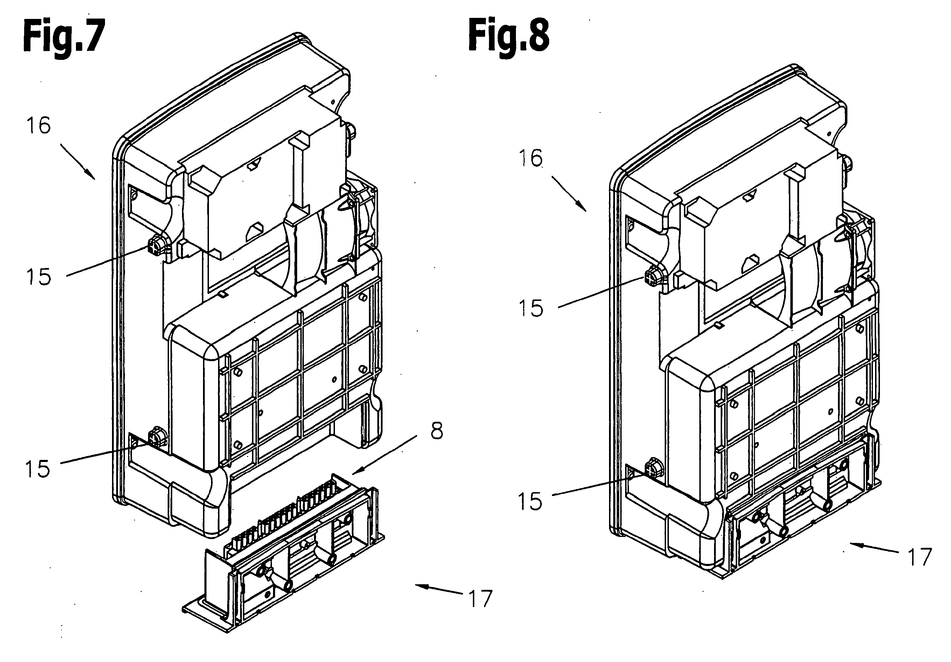

Somit kann ein sehr kompakt aufgebauter Wechselrichter 3 sehr einfach mit den Anschlusskabeln 5 verbunden werden. Der kompakte Aufbau des Wechselrichters 3 bezieht sich hierbei insbesondere auf den zweiten Teil 10 der Steckverbindung 7, also den Stecker, welcher geschützt an der Rückseite des Gehäuses 16 des Wechselrichters 3 angeordnet werden kann, da keine Zugänglichkeit zur Steckverbindung. 7 erforderlich ist. Der kompakte Aufbau ist aus den Fig. 7 und 8 ersichtlich. Hierin ist die Rückseite des Gehäuses 16 des Wechselrichters 3 mit dem integrierten zweiten Teil 10 der Steckverbindung 7 (Stecker) sowie der erste Teil 8 der Steckverbindung 7, welcher am Block 17 und in weiterer Folge an der nicht dargestellten Halterung 6 befestigt wird, gezeigt. Dabei ist der zweite Teil 10 der Steckverbindung 7 bzw. Stecker vom Gehäuse 16 verdeckt. Fig. 7 zeigt die getrennte Steckverbindung 7 und Fig. 8 die kontaktierte Steckverbindung 7. Bevorzugt wird der Stecker durch das Gehäuse 16 des Wechselrichters 3 geschützt und direkt mit einer Leiterplatte im Wechselrichter 3 verbunden. Der Stecker ist auf die maximale Leistung des Wechselrichters 3 und der Querschnitt der Anschlusskabel 5 auf die Leistung der Photovoltaikanlage 1, welche insbesondere von der Anzahl der Solarmodule 2 abhängt, abgestimmt. Die Kupplung zum Anschluss der Anschlusskabel 5 ist mit unterschiedlichem Querschnitt ausgebildet. Bevorzugt erfolgt dies in einfacher Weise derart, dass die Anschlusskabel 5 in der Kupplung angeschraubt werden. Dafür sind keine speziellen Werkzeuge oder Stecker an den Anschlusskabeln 5 erforderlich, wodurch ein schnelles Anschließen der Anschlusskabel 5 möglich ist.
Ergänzend kann zum kompakten Aufbau des Wechselrichters 3 aber auch ein Gehäuse 16 aus leichten Werkstoffen, wie Kunststoff, Aluminium oder Ähnlichem eingesetzt werden. Bei einem Gehäuse 16 aus Kunststoff kann der Wechselrichter 3 beispielsweise nach dem Einhängen und automatischen Kontaktieren mit einem metallischen Deckel geschützt werden. Dieser kann mit der Halterung 6 bevorzugt durch Schrauben verbunden sein, sodass der Wechselrichter 3 gemeinsam mit der Halterung 6 auch den Vorschriften der Elektromagnetischen Verträglichkeit (EMV) entspricht.

Selbstverständlich kann die automatische Kontaktierung auch derart erfolgen, dass der Wechselrichter 3 zuerst eingehängt wird und beim Schieben in Richtung der Rückwand 11 der Stecker mit der Kupplung verbunden wird. Dabei sind die Kontaktelemente der Steckverbindung 7 nicht vertikal angeordnet, sondern horizontal. Dementsprechend sind auch weitere ähnliche Ausführungen zur Durchführung der automatischen Kontaktierung möglich. Insbesondere ist das erfindungsgemäße Prinzip unabhängig davon, wo der Stecker bzw. die Kupplung der Steckverbindung 7 angeordnet ist. Ebenso kann die Führungsvorrichtung 9 beispielsweise auch in der Rückwand 11 der Halterung 6 angeordnet sein. Wesentlich ist, dass die Führungsvorrichtung 9 derart in der Halterung 6 positioniert wird, dass diese mit der Position der Kupplung der Steckverbindung 7 abgestimmt ist. Dadurch wird gewährleistet, dass der Stecker beim Einhängen des Wechselrichters 3 in der Halterung 6 automatisch mit der Kupplung der Steckverbindung 7 kontaktiert wird.

Weiters kann in der Steckverbindung 7 vorgesehen sein, dass bei der automatischen Kontaktierung eine Überspannungs-Schutzbeschaltung und/oder ähnliche Funktionen im Wechselrichter 3 aktiviert wird bzw. werden. Auf die Funktion der Überspannungs-Schutzbeschaltung wird nicht näher eingegangen, da diese allgemein aus dem Stand der Technik bekannt ist. Die Aktivierung erfolgt bevorzugt derart, dass eine in der Kupplung der Steckverbindung 7 zwischen zwei Kontaktelementen angeordnete Brücke im Wesentlichen als Schalter eingesetzt wird und beispielsweise die Überspannungs-Schutzbeschaltung aktiviert.

Bevorzugt ist zumindest teilweise ein Spalt zwischen der Rückwand 11 und der Steckverbindung 7 vorgesehen, sodass gegebenenfalls eindringendes Wasser bzw. durch Kondensation gebildetes Wasser abfließen kann.

Im Allgemeinen sei noch darauf hingewiesen, dass das erfindungsgemäße Prinzip der Halterung 6 anstelle oder zusätzlich zum Wechselrichter 3 beispielsweise auch bei einer so genannten und aus dem Stand der Technik bekannten String Control zur Überwachung der Strings bzw. Stränge einer Photovoltaikanlage eingesetzt werden kann.

## Patentansprüche

1. Halterung (6) für einen Wechselrichter (3) einer Photuvoltaikanlage (1), welche zur lösbaren Aufnahme des Wechselrichters (3) ausgebildet ist, wobei der Wechselrichter (3) über jeweils zumindest ein Anschlusskabel (5) mit zumindest einem Solarmodul (2) und einem Wechselspannungsnetz (4) verbindbar ist, und ein erster Teil (8) einer Steckverbindung (7) zum Anschluss der Anschlusskabel (5) des Wechselrichters (3) und weiters Vorrichtungen (9) zur Führung des Wechselrichters (3) vorgesehen sind, welche Führungsvorrichtungen (9) zum automatischen Kontaktieren des ersten Teils (8) der Steckverbindung (7) mit einem am Wechselrichter (3) angeordneten zweiten Teil (10) der Steckverbindung (7) ausgebildet sind, **dadurch gekennzeichnet, dass** die Halterung (6) durch eine Rückwand (11) und zwei Seitenwände (12) gebildet ist und die Führungsvorrichtungen (9) in den Seitenwänden (12) der Halterung (6) integriert sind, wobei die Führungsvorrichtungen (9) durch eine erste horizontale Führungsnut (13) und eine zweite vertikale Führungsnut (14) zur Führung des Wechselrichters (3) in zumindest zwei Schritten ausgebildet ist, sodass bei der Führung nach unten entlang der vertikalen Führungsnut (14) die automatische Kontaktierung zwischen dem ersten Teil (8) und dem zweiten Teil (10) der Steckverbindung (7) erfolgt.

2. Halterung (6) nach Anspruch 1, **dadurch gekennzeichnet, dass** die Führungsvorrichtungen (9) derart ausgebildet sind, dass nach dem ersten Schritt der erste Teil (8) der Steckverbindung (7) gegenüber dem zweiten Teil (10) der Steckverbindung (7) zum automatischen Kontaktieren positioniert ist.

3. Halterung (6) nach Anspruch 1 oder 2, **dadurch gekennzeichnet, dass** die Führungsvorrichtungen (9) derart ausgebildet sind, dass nach dem zumindest zweiten Schritt der Wechselrichter (3) in den Führungsvorrichtungen (9) gehalten ist.

4. Verfahren zur Montage eines Wechselrichters (3) einer Photovoltaikanlage (1), wobei ein Gehäuse (16) des Wechselrichters (3) in einer Halterung (6) eingehängt wird, welche Halterung (6) durch eine Rückwand (11) und zwei Seitenwände (12) gebildet ist, und Führungsvorrichtungen (9) in den Seitenwänden (12) der Halterung (6) integriert sind, wobei die Führungsvorrichtungen (9) durch eine erste horizontale Führungsnut (13) und eine zweite vertikale Führungsnut (14) zur Führung des Wechselrichters (3) in zumindest zwei Schritten ausgebildet ist, und der Wechselrichter (3) über jeweils zumindest ein Anschlusskabel (5) mit zumindest einem Solarmodul (2) und einem Wechselspannungsnetz (3) verbunden wird, wobei zuerst die Anschlusskabel (5) an einem mit der Halterung (6) verbundenen Teil (8) einer Steckverbindung (7) angeschlossen werden, und dann der mit einem zweiten Teil (10) der Steckverbindung (7) versehene Wechselrichter (3) durch das Einhängen bei der Führung nach unten entlang der vertikalen Führungsnut (14) in der Halterung (6) automatisch mit dem ersten Teil (8) der Steckverbindung (7) kontaktiert wird.

5. Montageverfahren nach Anspruch 4, **dadurch gekennzeichnet, dass** der Wechselrichter (3) nach dem Einhängen in der Halterung (6) in einer Position, in welcher die Teile (8, 10) der Steckverbindung (7) kontaktiert sind, gehalten wird.

6. Montageverfahren nach Anspruch 4 oder 5, **dadurch gekennzeichnet, dass** der Wechselrichter (3) mit Führungsbolzen (15) in entsprechenden Führungsnuten (14) in der Halterung (6) gehalten wird.

7. Montageverfahren nach einem der Ansprüche 4 bis 6, **dadurch gekennzeichnet, dass** ein Deckel zur Abschirmung des Wechselrichters (3) mit der Halterung (6) verbunden wird.

8. Montageverfahren nach einem der Ansprüche 4 bis 7, **dadurch gekennzeichnet, dass** beim Verbinden der Teile (8, 10) der Steckverbindung (7) eine Uberspannungs-Schutzbeschaltung des Wechselrichters (3) aktiviert wird.

## Claims

1. A mounting (6) for an inverter (3) of a photovoltaic system (1), which is designed to detachably accommodate the inverter (3), wherein the inverter (3) can be connected to at least one solar module (2) and an alternating current supply (4) via at least one connection cable (5) for each, and a first part (8) of a plug connector (7) for connecting the connection cables (5) of the inverter (3) and, furthermore, devices (9) for guiding the inverter (3) are provided, which guiding devices (9) are designed to automatically contact the first part (8) of the plug connector (7) with a second part (10) of the plug connector (7) that is arranged on the inverter (3), **characterised in that** the mounting (6) is formed by a rear wall (11) and two side walls (12) and the guiding devices (9) are integrated into the side walls (12) of the mounting (6), wherein the guiding devices (9) are formed by a first horizontal guiding groove (13) and a second vertical guiding groove (14) for guiding the inverter (3) in at least two steps, so that during the guiding down along the vertical guiding groove (14) the automatic contacting between the first part (8) and the second part (10) of the plug connector (7) is effected.

2. The mounting (6) according to claim 1, **characterised in that** the guiding devices (9) are designed in such a way that after the first step, the first part (8) of the plug connector (7) is positioned for automatic contacting with respect to the second part (10) of the plug connector (7).

3. The mounting (6) according to claim 1 or 2, **characterised in that** the guiding devices (9) are designed in such a way that after the at least second step, the inverter (3) is secured within the guiding devices (9).

4. A method for fitting an inverter (3) of a photovoltaic system (1), wherein a housing (16) of the inverter (3) is hooked to a mounting (6), which mounting (6) is formed by a rear wall (11) and two side walls (12), and guiding devices (9) are integrated into the side walls (12) of the mounting (6), wherein the guiding devices (9) are formed by a first horizontal guiding groove (13) and a second vertical guiding groove (14) for guiding the inverter (3) in at least two steps, and the inverter (3) is connected to at least one solar module (2) and an alternating current supply (4) via at least one connection cable (5) for each, wherein the connection cables (5) are first connected to a part (8) of a plug connector (7) that is connected to the mounting (6), and then the inverter (3), which is provided with a second part (10) of the plug connector (7), is automatically contacted with the first part (8) of the plug connector (7) by being hooked to the mounting (6) during the guiding down along the vertical guiding groove (14).

5. The fitting method according to claim 4, **characterised in that** after being hooked to the mounting (6), the inverter (3) is secured in a position in which the parts (8, 10) of the plug connector (7) are contacted.

6. The fitting method according to claim 4 or 5, **characterised in that** the inverter (3) is secured within the mounting (6) by means of guiding bolts (15) in corresponding guiding grooves (14).

7. The fitting method according to any of claims 4 to 6, **characterised in that** a cap for shielding the inverter (3) is connected to the mounting (6).

8. The fitting method according to any of claims 4 to 7, **characterised in that** during connection of the parts (8, 10) of the plug connector (7) an over-voltage protection circuit of the inverter (3) is activated.

## Revendications

1. Fixation (6) pour un onduleur (3) d'une installation photovoltaïque (1), laquelle est réalisée pour un montage amovible de l'onduleur (3), dans laquelle l'onduleur (3) peut être respectivement relié via au moins un câble de raccordement (5) à au moins un module solaire (2) et un réseau de tension alternative (4), et sont prévus une première partie (8) d'une fiche de raccordement (7) pour raccorder les câbles de raccordement (5) de l'onduleur (3) et, en outre, des dispositifs (9) pour guider l'onduleur (3), lesquels dispositifs de guidage (9) sont conçus pour une mise en contact automatique de la première partie (8) de la fiche de raccordement (7) avec une deuxième partie (10) de la fiche de raccordement (7), agencée sur l'onduleur (3), **caractérisée en ce que** la fixation (6) est formée par une paroi arrière (11) et deux parois latérales (12), et les dispositifs de guidage (9) sont intégrés dans les parois latérales (12) de la fixation (6), dans laquelle les dispositifs de guidage (9) sont formés par une première rainure de guidage horizontale (13) et une deuxième rainure de guidage verticale (14) en vue de guider l'onduleur (3) dans au moins deux étapes, de telle sorte qu'au moment du guidage vers le bas le long de la rainure de guidage verticale (14) se produit la mise en contact automatique entre la première partie (8) et la deuxième partie (10) de la fiche de raccordement (7).

2. Fixation (6) selon la revendication 1, **caractérisée en ce que** les dispositifs de guidage (9) sont réalisés de telle sorte que, après la première étape, la première partie (8) de la fiche de raccordement (7) est positionnée en regard de la deuxième partie (10) de la fiche de raccordement (7) en vue de la mise en contact automatique.

3. Fixation (6) selon la revendication 1 ou 2, **caractérisée en ce que** les dispositifs de guidage (9) sont réalisés de telle sorte que, après la au moins deuxième étape, l'onduleur (3) est maintenu dans les dispositifs de guidage (9).

4. Procédé de montage d'un onduleur (3) d'une installation photovoltaïque (1), dans lequel un boîtier (16) de l'onduleur (3) est accroché dans une fixation (6), laquelle fixation (6) est formée par une paroi arrière (11) et deux parois latérales (12), et des dispositifs de guidage (9) sont intégrés dans les parois latérales (12) de la fixation (6), dans lequel les dispositifs de guidage (9) sont formés par une première rainure de guidage horizontale (13) et une deuxième rainure de guidage verticale (14) en vue de guider l'onduleur (3) dans au moins deux étapes, et l'onduleur (3) est respectivement relié via au moins un câble de raccordement (5) avec au moins un module solaire (2) et un réseau de tension alternative (4), dans lequel procédé, tout d'abord, les câbles de raccordement (5) sont raccordés à une partie (8), reliée à la fixation (6), d'une fiche de raccordement (7), et ensuite l'onduleur (3), muni d'une deuxième partie (10) de la fiche de raccordement (7), est automatiquement mis en contact avec la première partie (8) de la fiche de raccordement (7) via l'accrochage dans la fixation (6) lors du guidage vers le bas le long de la rainure de guidage verticale (14).

5. Procédé de montage selon la revendication 4, **caractérisé en ce que** l'onduleur (3), après son accrochage dans la fixation (6), est maintenu dans une position, dans laquelle les parties (8, 10) de la fiche de raccordement (7) sont mises en contact.

6. Procédé de montage selon la revendication 4 ou 5, **caractérisé en ce que** l'onduleur (3) est maintenu dans la fixation (6) au moyen de boulons de guidage (15) dans des rainures de guidage (14) correspondantes.

7. Procédé de montage selon l'une quelconque des revendications 4 à 6, **caractérisé en ce qu'**un couvercle, destiné à protéger l'onduleur (3), est relié à la fixation (6).

8. Procédé de montage selon l'une quelconque des revendications 4 à 7, **caractérisé en ce qu'**un circuit limiteur de tension de l'onduleur (3) est activé au moment de la mise en relation des parties (8, 10) de la fiche de raccordement (7).
